# EUROPÄISCHE PATENTANMELDUNG

(11) **EP 2 056 345 A1**
(43) Veröffentlichungstag der Anmeldung: **06.05.2009**
(21) Anmeldenummer: 07021427.5
(22) Anmeldetag: 02.11.2007
(51) Int. Cl.: H01L 23/373

(54) **Wärmesenkenmodul für elektronische Bauteile oder Schaltkreise sowie Verfahren zu dessen Herstellung**

(71) Anmelder: PLANSEE SE, 6600 Reutte (AT)
(72) Erfinder: Knippscheer, Sven, Dr.-Ing., 6600 Reutte (AT); Mrotzek, Tobias, Dipl.-Ing., 6600 Reutte (AT); Reinfried, Nikolaus, Dipl.-Ing., 6600 Lechaschau (AT)
(74) Vertreter: Kador & Partner

(57) **Zusammenfassung**

Modul zur Verwendung als Wärmesenke für elektronische Bauteile oder Schaltkreise, welches eine Diamantschicht in Teilbereichen aufweist.

## Beschreibung

Die Erfindung bezieht sich auf ein Modul zur Verwendung als Wärmesenke, insbesondere eine aktiv gekühlte Wärmesenke für elektronische Bauteile oder integrierte Schaltkreise sowie ein Verfahren zu dessen Herstellung und dessen Verwendung.

Durch den schnellen Fortschritt in der Mikroelektronik, der drahtlosen Kommunikationstechnik sowie neuer Entwicklungen in der Lasertechnik sowie auf dem Gebiet der Luft- und Raumfahrttechnik werden steigende Ansprüche an die dort vewendeten elektronischen Bauteile gestellt. Derartige Bauteile müssen hoch leistungsfähig sein und ihre Abmessungen werden immer weiter minimiert. Derartige elektronische Bauteile bringen durch steigende Leistung erhöhte Wärmeverluste mit sich und müssen daher mit Substraten oder Basisplatten versehen werden, die als Wärmesenke oder Wärmespreizer dienen und effektiven Wärmeabfluss sicherstellen. Dies erfordert die Verwendung spezieller Hochleistungsmaterialien, die sowohl hohe Wärmeleitfähigkeit als auch geringe thermische Expansion aufweisen. Gleichzeitig müssen das Wärmeausdehnungsverhalten des Wärmesenkenmaterials und des elektronischen Bauteils möglichst ähnlich sein, um die Lebensdauer der Vorrichtung zu erhöhen.

Metallische und diamanthaltige Werkstoffe als Substratmaterialien für Wärmesenken sind bekannt, z.B. aus US-Patent Nr. 6,404,065 B1 und den internationalen Patentanmeldungen WO 2004/080913 A1 oder WO 2005/106952 A1.

In aktiv gekühlten Wärmesenken hat sich eine kanalartige Innenstruktur, so genannte Microchannels oder Makrochannels etabliert. Derartige Strukturen sind beispielsweise aus US 6,014,312, US 6,480,514 B1 oder US 5,099,311 bekannt. Im folgenden wird unter "aktiv gekühlter Wärmesenke" eine solche verstanden, in der die Wärmeabführung durch ein Kühlmedium, vorzugsweise ein flüssiges oder gasförmiges Kühlmittel unterstützt wird. Ein durch Verdampfung erzeugtes Kühlmittel ist ebenfalls vorstellbar. Als flüssige Kühlmittel können insbesondere, aber nicht abschließend Wasser oder Öl eingesetzt werden. Mit aktiv gekühlten Wärmesenken, v.a. solchen, die mit einem Kühlmedium aus Wasser gekühlt werden, sind Kühlleistungen mit Wärmeübergangskoeffizienten im Bereich von 1.000 bis 10.000 W/m²/K oder sogar über 80.000 W/m²/K erzielbar. Allerdings ist das Kühlmedium Wasser selbst Quelle von Korrosionserscheinungen, und infolge der Durchströmung der Wärmesenke auch von Erosionserscheinungen und muß daher meist deionisiert eingesetzt werden. In den bekannten Systemen lässt sich eine hohe Wärmeleitfähigkeit gekoppelt mit guter Anpassung der thermischen Ausdehnungskoeffizienten (α) von Wärmesenkenmaterial und elektronischem Bauteil (CTE-Anpassung) erreichen. Jedoch ist die elektrische Isolation der Wärmesenke gegenüber dem Kühlkreislauf weiter ein großes Problem. Selbst in deonisiertem Wasser können verbleibende elektrische Ladungen infolge der Durchströmung der Wärmesenke mit Kühlmedium zur Bildung von Lokalelementen führen, wodurch Korrosion und Erosion gefördert werden.

Es wurde daher versucht, die Wärmesenke gegenüber dem Kühlkreislauf elektrisch zu isolieren. Hierzu wurden beispielsweise keramische Schichten zwischen dem Wärmesenkenmaterial und dem elektronischen Bauteil aufgebracht. Derartige keramische Materialien bieten zwar eine elektrische Isolation, verringern jedoch drastisch die Wärmeleitfähigkeit zwischen Wärmesenke und Wärmequelle (elektronisches Bauteil), so dass die Kühlleistung infolge mangelnder Wärmeabführung und die CTE-Anpassung stark absinkt. Somit besteht ein Bedarf an elektrischer Isolierung der Wärmesenke gegenüber dem Kühlkreislauf bei gleichbleibend hoher Wärmeleitfähigkeit und CTE-Anpassung zwischen elektronischem Bauteil und Wärmesenkensubstrat. Weiterhin sollen Kosten und konstruktiver Aufwand gesenkt werden.

Es ist daher die Aufgabe der vorliegenden Erfindung, die vorstehenden Probleme zu lösen und ein verbessertes Modul zur Verwendung als Wärmesenke für elektronische Bauteile oder Schaltkreise, ein Verfahren zu dessen Herstellung und dessen Verwendung als Wärmesenke bereitzustellen.

Es wurde nun überraschenderweise gefunden, dass diese Aufgabe gelöst werden kann durch Bereitstellung eines aktiv gekühlten Moduls zur Verwendung als Wärmesenke, wie es in Anspruch 1 definiert ist. Die Aufgabe wird ebenfalls gelöst mit einem Verfahren zur Herstellung eines solchen Moduls gemäß Anspruch 8. Schließlich wird die Aufgabe gelöst durch die Verwendung gemäß Anspruch 15.

Erfindungsgemäß wird also ein Modul zur Verwendung als Wärmesenke für elektronische Bauteile oder Schaltkreise bereitgestellt, das aufweist:
(i) einen Grundkörper zur Kontaktierung mit dem elektronischen Bauteil oder Schaltkreis, der ein Substratmaterial aufweist,
(ii) eine mit Kanalstruktur ausgebildete Innenstruktur des Grundkörpers, wobei die Kanäle von einem Kühlmedium durchströmt werden,
   **dadurch gekennzeichnet, dass**
(iii) Teilbereiche der mit dem Kühlmedium in Kontakt stehenden Oberflächen des Grundkörpers und der Innenstruktur mit einer Diamantschicht versehen sind.

Die Innenstruktur des Grundkörpers, die mit Kanalstruktur ausgebildet ist, kann eine oder mehrere Kühlerlagen aufweisen, die durch geeignete Anordnung Mikro- oder Makrokanäle bilden können. Der Grundkörper kann aus einer oder mehreren Komponenten bestehen. Eine dieser Komponenten kann ein den Grundkörper ab- bzw. verschließendes Deckelement sein. Bevorzugt besteht der Grundkörper aus mehreren Lagen oder Schichten, die zusammengefügt werden, um den fertigen Grundkörper zu bilden. Grundsätzlich können Grundkörper und Innenstruktur durch mechanische Bearbeitung, Formätzen, übliche pulvermetallurgische Verfahren wie z.B. Heißpressen oder Sintern und insbesondere im Falle von Graphit- bzw. Diamantverbundmaterialien auch mittels Infiltration hergestellt werden. Die entsprechenden Verfahrensmaßnahmen sind dem Fachmann gut bekannt.

Als Substratmaterialien für Wärmesenken haben sich metallische Materialien wie Kupfer sowie Kupferbasislegierungen, Kupferverbundwerkstoffe mit Molybdän oder Wolfram, ein Laminat aus Kupfer und einem Kupferverbundwerkstoff mit Molybdän oder Wolfram, ein Diamantverbund-Substrat oder ein Graphitverbund-Substrat bewährt. Insbesondere vorteilhaft ist ein Diamantverbund-Substrat. Hierbei kann ein Verbund von Diamanten mit mindestens einem Element oder einer Legierung aus der Gruppe bestehend aus Aluminium, Kupfer, Silber und Gold und gegebenenfalls einem karbidbildenden Element wie z.B. Silizium, Yttrium, Scandium, Bor, Chrom, Titan, Molybdän, Wolfram und einem Seltenerdmetall oder ein Verbund von Diamant mit Siliciumcarbid eingesetzt werden. Diamantverbundmaterialien besitzen insbesondere gute Wärmeleitfähigkeit bis 900 W/mK (20 °C), insbesondere von 300 bis 750 W/mK (20 °C) nach ASTM 1461-01 und geringe Wärmeausdehnung mit einem Wärmeausdehnungskoeffizienten α im Bereich von 1 bis 10 (10 ⁶/K / 20 °C), insbesondere von 2 bis 8 (10⁻⁶/K / 20 °C), weiter bevorzugt von 4 bis 8 (10⁻⁶/K / 20 °C) nach DIN 51045.

Alternativ können Substrate aus Kupfer, oder bevorzugt einem Kupferverbundwerkstoff, wie beispielsweise Molybdän-Kupfer (MoCu), Wolfram-Kupfer (WCu) eingesetzt werden. Hierbei wird das dem Kupfer zugesetzte Metall mit einem Gehalt von 30 bis 95 Gew.-%, insbesondere von 50 bis 90 Gew.-%, weiter bevorzugt von 50 bis 80 Gew.-%, bezogen auf das Gesamtgewicht des Verbundwerkstoffes eingesetzt. Im Falle von MoCu sind Molybdängehalte von 50 bis 70 Gew.-%, im Falle von WCu sind Wolframgehalte von 90, 88, 85 oder 80 Gew.-% ebenfalls bevorzugt. Als Laminate haben sich insbesondere solche bewährt, die aus einer Kupferschicht, einem Molybdän-Kupfer-Verbundwerkstoff sowie einer weiteren Kupferschicht bestehen (sof. Cu/MoCu/Cu-Laminat). Sie können eine Wärmeleitfähigkeit von mehr als 200 W/mK (20 °C), bevorzugt mehr als 250 W/mK (20 °C), gemessen "in plane" nach ASTM 1461-01 und einen Wärmeausdehnungskoeffizienten α von 5 bis 12 (10⁻⁶/K / 20 °C), bevorzugt 8 bis 10 (10⁻⁶/K / 20 °C) nach DIN 51045 aufweisen.

Zur Vorbereitung einer Diamantabscheidung auf einem dieser Substratmaterialien kann insbesondere im Fall eines Kupfersubstrats, eines Kupferverbundsubstrats oder eines Laminats aus Kupfer und einem Kupferverbundwerkstoffes ein Legierungszusatz verwendet werden, der ein Carbidbildner ist. Hierfür kommen beispielsweise Chrom, Titan, Silicium, Bor, Molybdän, Vanadium. Wolfram und Eisen infrage. Diese Legierungszusätze können auch mittels chemischer oder physikalischer Dampfabscheidung auf das Substratmaterial aufgebracht werden.

Die in den Grundkörper eingebrachte Innenstruktur zur Ausbildung der Kanalstruktur kann jede mögliche Form aufweisen. So sind einfache Kühlkanäle, die zur Wärmequelle hinführen und von dieser abgeführt werden, denkbar (sog. Makrochannels) Diese sind insbesondere zur Kühlung von Bauteilen mit einer thermischen Leistung von bis zu 50 oder 60 W geeignet. Hierbei kann das Design des Kühlkanals oder der Kühlkanäle so ausgelegt sein, dass das Kühlmedium im Bereich oder unterhalb der Wärmequelle beschleunigt strömt (z.B. mit einer Flußrate von 0,3 bis 0,8 l/min.; Druckabfall 0,5-1,5 bar)

Insbesondere für die Ausbildung von Mikrokanälen haben sich mehrere Kühlerlagen bewährt, die stapelartig übereinander angeordnet und flächig miteinander verbunden sein können, so dass diese von einem Kühlmedium durchströmbare Kanäle bilden, welche in einen Sammelraum zum Zuführen des Kühlmediums und in einen Sammelraum zum Abführen des Kühlmediums münden können. Jedoch sind hiervon verschiedene, beliebige Konstruktionen denkbar. Diese sog. Mikrochannel-Wärmesenken sind insbesondere zur Kühlung von Hochleistungsbauteilen mit einer Abgabeleistung von über 100 W geeignet.

Erfindungsgemäß werden Teilbereiche der mit dem Kühlmedium in Kontakt stehenden Oberflächen der Innenstruktur sowie des Grundkörpers mit einer Diamantschicht auf dem Substratmaterial versehen. Vorzugsweise sind sämtliche der mit dem Kühlmedium in Kontakt stehenden Oberflächen mit einer Diamantschicht auf dem Substratmaterial versehen. Geeigneterweise werden Schichtdicken von 0,1µm bis 10µm, bevorzugt von 0,5µm bis 3µm aufgebracht. Die bevorzugte Verfahrensweise der chemischen Dampfabscheidung wird nachstehend genauer beschrieben.

Diese erfindungsgemäße Diamantschicht sorgt für eine sichere elektrische Isolation des Wärmesenkenmaterials gegenüber dem Kühlkreislauf und ermöglicht ferner die Wärmesenke in direktem elektrischem Kontakt mit dem elektronischen Bauteil einzusetzen. Ein weiterer Vorteil ist es, dass anstelle von deonisiertem Wasser übliches Brauchwasser eingesetzt werden kann. Es kann ferner vorteilhafterweise auf elektrisch isolierende Schichten, beispielsweise solche aus Keramikmaterialien wie AIN, BeO, Al₂O₃ oder organischen Materialien zwischen Wärmesenkenmaterial und elektronischem Bauteil verzichtet werden. Dies führt, gegenüber den keramischen oder organischen Zwischenschichten, zu einer stark erhöhten Wärmeleitfähigkeit, also der Wärmeabführung vom Bauteil und zu einer besseren CTE-Anpassung zwischen Bauteil und Wärmesenke. Daraus folgt eine weiter verbesserte Lebensdauer des Moduls gegenüber den keramischen Isolierungen. Außerdem lässt sich das Design elektronischer Packages durch Verzicht auf die erwähnten Zwischenschichten oder sog. Submounts vereinfachen und es werden Kosten eingespart.

Insbesondere in Kombination mit einem Diamantverbund als Wärmesenkensubstrat lassen sich stark verbesserte elektronische Packages herstellen, die ohne Zwischenschichten oder Submounts auskommen und dennoch die vorstehend beschriebenen Vorteile aufweisen. Auch vorteilhaft als Wärmesenkensubstrat einsetzbar sind Graphitverbunde, wobei der Graphit als Fasern, Partikel oder auch Nanotubes in eine Metallmatrix eingelagert werden kann.

Das erfindungsgemäße Verfahren zur Herstellung des Moduls ist gekennzeichnet durch folgende Schritte:
(a) Bereitstellung eines ein Substratmaterial aufweisenden Grundkörpers zur Kontaktierung mit einem elektronischen Bauteil oder Schaltkreis,
(b) Bereitstellung einer mit Kanalstruktur ausgebildeten Innenstruktur für den Grundkörper, wobei die Kanäle vorgesehen sind, um von einem Kühlmedium durchströmt zu werden,
(c) Verbindung von Grundkörper und Innenstruktur,
(d) Aufbringen einer Diamantschicht auf die Oberflächen des Grundkörpers und der Innenstruktur, die mit dem Kühlmedium in Kontakt stehen können, wobei Schritt (d) vor oder nach Schritt (c) erfolgt, und
(e) gegebenenfalls Verschließen des Grundkörpers.

Der Grundkörper kann hierbei verschiedenartig konstruiert sein und insbesondere bevorzugt so aufgebaut sein wie er vorstehend beschrieben wurde.

Grundkörper und Innenstruktur können vorzugsweise mittels Löten oder Bonding, insbesondere bevorzugt durch Diffusionsbonden verbunden werden.

Das Verlöten der einzelnen Lagen des Bauteiles findet unter Vakuum statt (10⁻⁵ bis 10⁻⁶ bar). Die Prozesstemperatur beträgt 500°C bis 900°C. Es wird ein Hochtemperaturlot mit aktiven Elementen (z. B. In-Cu-Ag-Basis Lote) verwendet.

Der Diffusionsbonding-Prozess wird ebenfalls im Vakuum ausgeführt (10⁻³ bis 10⁻⁴ bar). Die zu bondenden Einzellagen werden übereinander gelegt und während des Prozesses mit einem Druck beaufschlagt (20 bis800 MPa). Die Prozesstemperaturen differieren je nach Material. Die vorstehend angegebenen Laminate und Legierungen werden bei Temperaturen von 200 °C bis 1000 °C, Diamantverbunde bei Temperaturen von 50 °C bis 800 °C gebondet, wobei aluminiumhaltige Diamantverbunde bevorzugt zwischen 50 °C und 550 °C und silber- bzw. kupferhaltige Diamantverbunde bevorzugt zwischen 100 °C bis 800 °C gebondet werden.

Es ist insbesondere bevorzugt, die Diamantschicht mittels Durchströmen der Kanalstruktur in dem fertiggestellten Grundkörper mit einem oder mehreren Reaktionsgasen aufzubringen. Vorzugsweise wird die Diamantschicht auf den genannten Oberflächen des Wärmesenkensubstrats und der Innenstruktur des Grundkörpers mittels chemischer Dampfabscheidung (CVD) aufgebracht. Anders Verfahren sind jedoch denkbar, z.B. physikalische Dampfabscheidung (PVD).

Die chemische Dampfabscheidung wird üblicherweise wie folgt durchgeführt:

Grundsätzlich wird ein Rohmaterialgas, das eine Kohlenstoffquelle und Wasserstoff enthält, zersetzt und aktiviert und der Kohlenstoff wird als Diamant in Film- bzw. Schichtform auf dem Substrat abgeschieden. Als Kohlenstoffquelle dient gewöhnlich Methan (CH₄), aber andere Kohlenstoffverbindungen wie Acetylen, Benzol, Ethanol, Aceton u.a. sind ebenfalls verwendbar. Die Zugabe einer geringen Menge eines sauerstoffhaltigen Gases wie O₂, CO, CO₂, u.a. kann die Eigenschaften des abgeschiedenen Diamantfilmes verbessern. Methan wird üblicher Weise mit einer Konzentration von 1 bis 10 Vol.-%, bevorzugt 2 bis 5 Vol.-% in reinem Wasserstoff eingesetzt, wobei jeder beliebige Zwischenwert innerhalb dieser Bereiche möglich ist. Weitere Prozessvarianten sind dem Fachmann z.B. aus US-Patent Nr. 5,445,106 gut bekannt, dessen Inhalt durch Bezugnahme hierin eingeschlossen ist.

Der Prozess läuft grundlegend in 2 Phasen ab:
(a) Reinigung des Substrates im Plasma (ohne aktive Prozessgase)
   Befreiung von Tensiden (Reste aus Vorreinigung)
(b) Aktivierung der Substratoberfläche und Abscheidung:
   Einleitung des Prozessgases - Abscheidung der Schichten, ggfs. unterstützt durch Substratheizung + BIAS + Dual lon Beam. Die Prozesstemperaturen liegen allgemein im Bereich zwischen 400 °C. bis 1100 °C. In der Prozesskammer herrscht gewöhnlich ein Druck von 0,1 bis 1 mbar. Zur Realisierung kristalliner (amorph nicht gewünscht) Diamantschichten ist ebenfalls eine Verdichtung des auf dem Substrat abgeschiedenen Kohlenstoffs notwendig. Diese Verdichtung kann z.B. mittels einer angelegten BIAS-Spannung (negative Spannung am Substrat) oder/und durch Heizung des Substrates oder/und "Dual Ion Beam" erreicht werden. Bei der Dual Ion Beam Technik werden zusätzliche Ar-lonen (ausserhalb des Plasmas) auf die abgeschiedene Schicht "geschossen" und dadurch eine weitere Verdichtung der Schicht erzielt. Es kann auch nach Abscheidung des Diamantfilmes, kurzzeitig reiner Wasserstoff in die Kammer eingeleitet werden, um graphitartige Strukturen des Filmes zu entfernen.

Eine insbesondere bevorzugte Prozessvariante (Mikrowellen-Plasma CVD) wird folgendermaßen durchgeführt:
In einer Prozesskammer wird ein Plasma gezündet. Dazu wird Ar-Gas ionisiert. Die Anregung des Ar-Gases erfolgt mittels Mikrowellen (Frequenz 2,45 GHz) sowie eines überlagerten Magnetfeldes (Feldstärke 875 Gauss). Das zu beschichtende Substratmaterial kann sowohl im Plasma als auch außerhalb des Plasmas lokalisiert werden. In der Prozesskammer wird ein Druck von 0,3 mbar eingestellt. In das Plasma wird ein Gasgemisch aus CH₄ (4 Vol%) + H₂(96 Vol%) eingeleitet. Die Fließgeschwindigkeit beträgt 150 sccm. CH₄ liefert den für die Erzeugung der Diamantschicht notwendigen Kohlenstoff. H₂ sorgt dafür, dass die sp³-hybridisierten Anteile im Prozessgas ausreichend hoch sind. Es wird ein Temperaturbereich von 700 °C bis 800 °C eingestellt.

Gemäß einer bevorzugten Ausführungsform der Erfindung wird das Modul hergestellt, indem ein Grundkörper, bestehend aus einem Hohlkörper und einem diesen abschließenden Deckelement bereitgestellt, wobei das Substrat für den Hohlkörper und das Deckelement aus einem Molybdän-Kupferverbundwerkstoff (MoCu) bestehen. Die Kühlkanäle enthaltende Innenstruktur des Grundkörpers ist ebenfalls aus einem Molybdän-Kupferverbundwerkstoff gefertigt. Anschließend werden alle Oberflächen des Hohlkörpers, der Innenstruktur sowie des Deckelements, die mit dem Kühlmedium in Kontakt stehen können, mittels CVD bei Bedingungen gemäß der vorstehenden insbesondere bevorzugten Prozessvariante mit einer Diamantbeschichtung von 3 µm versehen. Daraufhin werden das Deckelement sowie der Hohlkörper mittels Diffusionsbonden verschlossen. Das Diffusionsbonden wird vorzugsweise bei einem Druck im Bereich der Fließspannung der zu verbindenden Materialien durchgeführt. In diesem Fall wird bei T = 800°C und p = 150 MPa gearbeitet.

Gemäß einer weiteren Ausführungsform der Erfindung besteht das Wärmesenkenmaterial für den Hohlkörper und das Deckelement für das Modul aus einem Cu/MoCu/Cu-Laminat. Der Hohlkörper weist 3 Einzellagen aus dem Laminat auf. Die Innenstruktur weist mehrere miteinander in Verbindung stehende schichtartig übereinander angeordnete Kühlerlagen auf. Auch diese bestehen aus dem genannten Laminat. Die Strukturierung der Einzellagen erfolgt durch Ätzen oder Stanzen. Bei der Fertigung des Grundkörpers werden Kupferoberflächen oder Molybdän-Kupferoberflächen, die später mit Diamant beschichtet werden sollen, vorher mit einem Legierungszusatz, der ein Carbidbildner (z.B. Titan oder Chrom) ist, mittels PVD beschichtet. Dies erhöht die Adhäsion und Nukleierung für die anschließende Diamantabscheidung. Anschließend werden die Einzellagen mit dem Grundkörper sowie Grundkörper und Deckelement mittels Diffusionsbonden zu einer fertigen Struktur verbunden. Die Diamantabscheidung erfolgt durch Innenbeschichtung des Grundkörpers, indem das Prozessgas durch Ein- und Auslass des Kühlmediums hindurchströmt. Ansonsten wird bei Bedingungen wie im vorstehenden Ausführungsbeispiel gearbeitet. Dies ermöglicht eine besonders effektive und vollständige Beschichtung der dem Kühlmedium ausgesetzten Oberflächen mit dem Diamant.

Gemäß einer weiteren bevorzugten Ausführungsform der Erfindung wird der wie in der vorstehenden Ausführungsform ausgebildete Hohlkörper und das Deckelement aus einem Diamant-Silberverbund gefertigt. Die Kühlkanäle enthaltende Innenstruktur, die U-förmig ausgebildet ist, besteht aus dem gleichen Material. Innenstruktur und Grundkörper werden mittels Löten miteinander verbunden. Anschließend erfolgt die Diamantabscheidung auf den Hohlkörperinnenflächen sowie der Innenseite des Deckelements mittels chemischer Dampfabscheidung bei den vorgenannten Bedingungen. Abschließend wird der Hohlkörper durch Verlötung mit dem Deckelement verschlossen. Das Löten wird in den vorstehend erwähnten Schritten bei einer Prozesstemperatur von 750 °C und einem Druck von 5*10⁻⁵ mbar sowie mit einem In-Cu-Ag-Basislot-Lot durchgeführt.

Das erfindungsgemäße Modul wird vorteilhaft als Wärmesenke in Verbindung mit elektronischen Bauteilen für die Leistungselektronik, Optoelektronik oder Mikroelektronik verwendet. Insbesondere geeignet sind der Einsatz zur Kühlung von Laserdioden, Halbleiterbauteilen, Leistungstransistoren (z.B. IGBTs) oder integrierten Schaltkreiselementen oder zum Aufbau von Packages für die Glasfaseroptik. Insbesondere vorteilhaft sind bei derartigen Einsätzen der einfache Einsatz, von Brauchwasser als Kühlmedium bei gleichzeitiger elektrischer Isolierung der Wärmesenke gegenüber dem Kühlkreislauf und gleichbleibend hoher Wärmeleitfähigkeit sowie guter CTE-Anpassung ohne Einsatz von zeit- und kostenaufwändigen Zwischenschichten zwischen Wärmesenke und elektronischem Bauteil. Die elektrischen Anschlüsse für das Bauteil können direkt auf dem Wärmesenkenmaterial vorgesehen werden.

## Patentansprüche

1. Modul zur Verwendung als Wärmesenke für elektronische Bauteile oder Schaltkreise, das aufweist:
(i) einen Grundkörper zur Kontaktierung mit dem elektronischen Bauteil oder Schaltkreis, der ein Substratmaterial aufweist,
(ii) eine mit Kanalstruktur ausgebildete Innenstruktur des Grundkörpers, wobei die Kanäle von einem Kühlmedium durchströmt werden,
**dadurch gekennzeichnet, dass**
(iii) Teilbereiche der mit dem Kühlmedium in Kontakt stehenden Oberflächen des Grundkörpers und der Innenstrukur mit einer Diamantschicht versehen sind.

2. Modul nach Anspruch 1, **dadurch gekennzeichnet, dass** alle mit dem Kühlmedium in Kontakt stehenden Oberflächen des Grundkörpers und der Innenstrukur mit einer Diamantschicht versehen sind.

3. Modul nach Anspruch 1 oder 2, **dadurch gekennzeichnet, dass** die Innenstruktur eine oder mehrere Kühlerlagen aufweist, die eine Kanalstruktur bilden.

4. Modul nach Anspruch 1 oder 2, **dadurch gekennzeichnet, dass** der Grundkörper aus mehreren Komponenten besteht, die zusammengefügt werden, um den fertigen Grundkörper zu bilden.

5. Modul nach einem der vorhergehenden Ansprüche, **dadurch gekennzeichnet, dass** die mit Diamant beschichteten Oberflächen aus einem Material bestehen, ausgewählt aus: Kupfer, einer Kupferlegierung, einem Kupferverbundwerkstoff mit Molybdän, oder Wolfram, einem Laminat aus Kupfer und einem Kupferverbundwerkstoff, einem Diamantverbund-Substrat, und einem Graphitverbund-Substrat.

6. Modul nach Anspruch 5, **dadurch gekennzeichnet, dass** das Diamantverbund-Substrat ein Verbund von Diamant mit mindestens einem Element oder einer Legierung aus der Gruppe bestehend aus Kupfer, Silber, Aluminium, Gold und gegebenenfalls einem karbidbildenden Element aus der Gruppe bestehend aus Silizium, Yttrium, Scandium, Bor, Chrom, Titan, Molybdän, Wolfram und einem Seltenerdmetall, oder ein Verbund von Diamant mit Siliciumcarbid (SiC) ist.

7. Modul nach Anspruch 5 oder 6, **dadurch gekennzeichnet, dass** das Kupfer- oder Kupferverbundsubstrat einen Legierungszusatz enthält, der ein Karbidbildner ist.

8. Modul nach einem der vorhergehenden Ansprüche, **dadurch gekennzeichnet, dass** die Diamantschicht mittels chemischer Dampfabscheidung (CVD) aufgebracht ist.

9. Modul nach einem der vorhergehenden Ansprüche, **dadurch gekennzeichnet, dass** das Kühlmedium aus Wasser und einem Öl ausgewählt ist.

10. Verfahren zur Herstellung eines Moduls nach einem der vorhergehenden Ansprüche, **gekennzeichnet durch** die folgenden Schritte:
(a) Bereitstellung eines ein Substratmaterial aufweisenden Grundkörpers zur Kontaktierung mit einem elektronischen Bauteil oder Schaltkreis,
(b) Bereitstellung einer mit Kanalstruktur ausgebildeten Innenstruktur für den Grundkörper, wobei die Kanäle vorgesehen sind, um von einem Kühlmedium durchströmt zu werden
(c) Verbinden von Grundkörper und Innenstruktur,
(d) Aufbringen einer Diamantschicht auf die Oberflächen des Grundkörpers und der Innenstruktur, die mit dem Kühlmedium in Kontakt stehen können, wobei Schritt (d) vor oder nach Schritt (c) erfolgt, und
(e) gegebenenfalls Verschließen des Grundkörpers.

11. Verfahren nach Anspruch 10, **dadurch gekennzeichnet, dass** Grundkörper und Innenstruktur mittels Löten oder Diffusionsbonding verbunden werden.

12. Verfahren nach Anspruch 10 oder 11, **dadurch gekennzeichnet, dass** die Diamantschicht mittels chemischer Dampfabscheidung (CVD) aufgebracht wird.

13. Verfahren nach Anspruch 12, **dadurch gekennzeichnet, dass** die chemische Dampfabscheidung mittels Durchströmen der Kanalstruktur in dem fertiggestellten Grundkörper mit einem oder mehreren Reaktionsgasen erfolgt.

14. Verfahren nach einem der Ansprüche 10 bis 13, **dadurch gekennzeichnet, dass** die mit Diamant zu beschichtenden Oberflächen aus einem Material gefertigt werden, ausgewählt aus: Kupfer, einer Kupferlegierung, einem Kupferverbundwerkstoff mit Molybdän oder Wolfram, einem Laminat aus Kupfer und einem Kupferverbundwerkstoff, einem Diamantverbund-Substrat, und einem Graphitverbund-Substrat.

15. Verfahren nach Anspruch 14, **dadurch gekennzeichnet, dass** die mit Diamant beschichteten Oberflächen aus einem Material gefertigt werden, das ein Verbund von Diamant mit mindestestens einem Element oder einer Legierung aus der Gruppe bestehend aus Kupfer, Silber, Aluminium, Gold und gegebenenfalls einem karbidbildendem Element aus der Gruppe bestehend aus Silizium, Yttrium, Scandium, Bor, Chrom, Titan, Molybdän, Wolfram und einem Seltenerdmetall, oder ein Verbund von Diamant mit Siliciumcarbid (SiC) ist.

16. Verfahren nach Anspruch 14, **dadurch gekennzeichnet, dass** ein Substrat aus Kupfer, einer Kupferlegierung, einem Kupferverbundwerkstoff oder einem Laminat aus diesen vor Diamantaufbringung mit einem Element behandelt wird, das ein Karbidbildner ist.

17. Verfahren nach einem der Ansprüche 10 bis 16, **dadurch gekennzeichnet, dass** die Aktivkühlung durch Flüssig- oder Verdampfungskühlung erfolgt.

18. Verwendung eines Moduls nach einem der Ansprüche 1 bis 9 als Wärmesenke für elektronische Bauteile oder Schaltkreise.

19. Verwendung nach Anspruch 18, **dadurch gekennzeichnet, dass** das elektronische Bauteil in der Optoelektronik, Mikroelektronik oder der Leistungselektronik eingesetzt wird.
